(19) Europäisches Patentamt
European Patent Office
Office européen des brevets

(11) **EP 1 776 725 B1**

(12) **EUROPÄISCHE PATENTSCHRIFT**

(45) Veröffentlichungstag und Bekanntmachung des Hinweises auf die Patenterteilung:
**30.06.2010 Patentblatt 2010/26**

(21) Anmeldenummer: **05774391.6**

(22) Anmeldetag: **04.08.2005**

(51) Int Cl.:
***H01L 41/107*** *(2006.01)*

(86) Internationale Anmeldenummer:
**PCT/DE2005/001384**

(87) Internationale Veröffentlichungsnummer:
**WO 2006/015581 (16.02.2006 Gazette 2006/07)**

(54) **PIEZOELEKTRISCHER TRANSFORMATOR**

PIEZOELECTRIC TRANSFORMER

TRANSFORMATEUR PIEZO-ELECTRIQUE

(84) Benannte Vertragsstaaten:
**DE**

(30) Priorität: **13.08.2004 DE 102004039425**

(43) Veröffentlichungstag der Anmeldung:
**25.04.2007 Patentblatt 2007/17**

(73) Patentinhaber: **EPCOS AG**
**81669 München (DE)**

(72) Erfinder:
• **FLORIAN, Heinz**
  **8524 Bad Gams (AT)**
• **GLAZUNOV, Alexander**
  **A-8530 Deutschlandsberg (AT)**
• **KARTASHEV, Igor**
  **8530 Deutschlandsberg (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 1 220 338      US-A1- 2002 074 903**
**US-A1- 2002 074 903**

• **PATENT ABSTRACTS OF JAPAN Bd. 2000, Nr. 12, 3. Januar 2001 (2001-01-03) -& JP 2000 244033 A (MURATA MFG CO LTD), 8. September 2000 (2000-09-08)**
• **PATENT ABSTRACTS OF JAPAN Bd. 1995, Nr. 06, 31. Juli 1995 (1995-07-31) -& JP 07 059338 A (NEC CORP), 3. März 1995 (1995-03-03)**
• **PATENT ABSTRACTS OF JAPAN Bd. 2003, Nr. 02, 5. Februar 2003 (2003-02-05) -& JP 2002 314160 A (MURATA MFG CO LTD), 25. Oktober 2002 (2002-10-25)**

**Beschreibung**

Ein piezoelektrischer Transformator ist dazu geeignet, eine hohe Spannung in eine niedrige Spannung zu transformieren, oder umgekehrt.

Piezoelektrische Transformatoren sind z. B. aus der Druckschrift US 2,830,274 bekannt.

JP 7-59338 und US 2002/74903 A1 offenbaren piezoelektrische Tranformatoren mit zwei Eingangs- bzw. Ausgangsabschnitten mit jeweiligen Innenelektrodengruppen.

Eine zu lösende Aufgabe besteht darin, einen Piezotransformator anzugeben, der einerseits gute elektrische Eigenschaften und andererseits eine hohe Durchschlagfestigkeit aufweist.

Der Piezotransformator umfasst einen Grundkörper, der einen Eingangsteil und einem Ausgangsteil aufweist. In wenigstens einem dieser Teile sind mindestens drei Gruppen von Innenelektroden enthalten, wobei die Innenelektroden jeweils einer Gruppe untereinander elektrisch leitend verbunden sind und von den Innenelektroden einer anderen Gruppe elektrisch isoliert sind.

Der Piezotransformator umfasst vorzugsweise mindestens zwei mechanisch miteinander verbundene Teile, einen Eingangsteil (Primärseite) und einen Ausgangsteil (Sekundärseite). Jeder Teil weist Schichten piezoelektrischer Keramik auf, wobei zwischen zwei aufeinander folgenden Schichten eine Innenelektrode angeordnet ist. Die Innenelektroden derselben Polarität sind mittels einer auf der Oberfläche des Grundkörpers angeordneten Außenelektrode (Sammelelektrode) leitend miteinander verbunden.

Zwischen dem Eingangsteil und dem Ausgangsteil des Transformators kann eine Isolationsschicht angeordnet sein.

Die piezoelektrische Keramik in den Schichten des Eingangsteils und Ausgangsteils kann beim Anlegen einer elektrischen Spannung an die Außen- bzw. Innenelektroden dieses Grundkörperteils polarisiert werden.

Der Eingangsteil bzw. der Ausgangsteil umfasst mindestens zwei Abschnitte, die elektrisch voneinander isolierte Außenelektroden auf den Seitenflächen des Körpers des piezoelektrischen Transformators aufweisen. Die Keramikschichten dieser Abschnitte weisen zueinander entgegengesetzt gerichtete Polarisierungen auf bezüglich der Innenelektroden, die an die gemeinsame Außenelektrode angeschlossen sind.

Die benachbarten Abschnitte desselben Teils (Eingangsteils oder Ausgangsteils) weisen leitend miteinander verbundene Außenelektroden auf, die auf der Oberfläche des Grundkörpers angeordnet sind. Die miteinander zu verbindenden Außenelektroden, die verschiedenen Abschnitten des Grundkörperteils zugeordnet sind und die jeweils einen Teil einer Sammelschiene bilden, an die die ersten Innenelektroden dieser Abschnitte angeschlossen sind, sind auf entgegengesetzten Seitenflächen des Grundkörpers angeordnet.

Erfindungsgemäß sind zwei auf entgegengesetzten Seitenflächen des Grundkörpers angeordnete Außenelektroden der benachbarten Abschnitte desselben Grundkörperteils (Eingangs- oder Ausgangsteils) mittels mindestens einer Innenelektrode miteinander elektrisch verbunden.

Der mit dem angegebenen Piezotransformator erzielte Vorteil ist zweifach. Erstens kann durch das Anpassen der Dicke der Keramikschichten relativ zur Breite des Isolationsbereichs eine bessere Polarisierung des Keramikmaterials erreicht werden. Zweitens kann die Breite des aktiven Bereichs relativ zur Gesamtbreite des Transformators groß gewählt werden. Beide Faktoren führen zu einer besseren Performance des piezoelektrischen Transformators.

Im Folgenden wird der Piezotransformator und die Anordnung mit einem Piezotransformator anhand schematischer und nicht maßstabsgetreuer Figuren erläutert. Es zeigen schematisch:

Figur 1    einen beispielhaften Piezotransformator;
Figur 2    ausschnittsweise einen in zwei Abschnitte unterteilten Eingangsteil des Piezotransformators, wobei die elektrischen Anschlüsse des Eingangsteils an derselben Seitenfläche des Grundkörpers angeordnet sind;
Figur 3    ausschnittsweise einen in zwei Abschnitte unterteilten Eingangsteil des Piezotransformators, wobei zwei auf unterschiedlichen Seitenflächen des Grundkörpers angeordnete, verschiedenen Abschnitten zugeordnete Außenelektroden über eine Innenelektrode leitend verbunden sind.

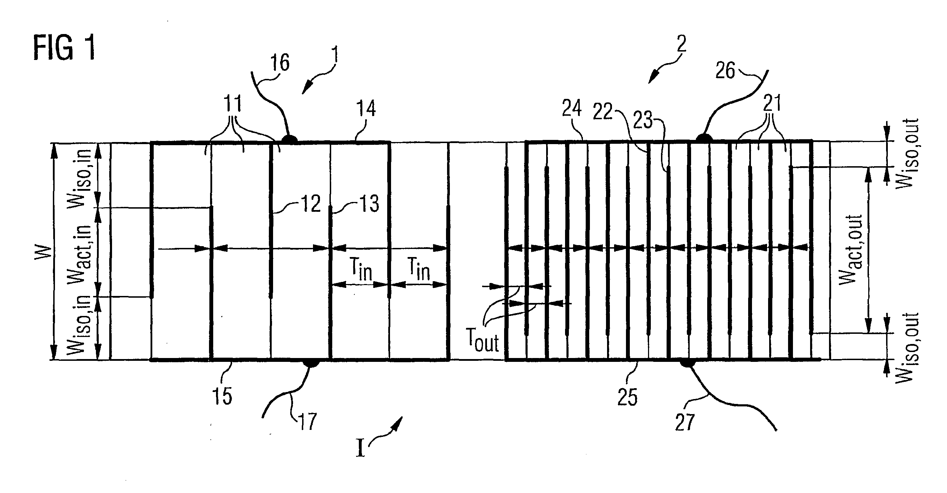

Figur 1 zeigt ein Beispiel für einen bekannten mehrschichtigen piezoelektrischen Transformator. Der Transformator weist einen Eingangsteil 1 und einen Ausgangsteil 2 auf. Diese Teile sind mechanisch miteinander verbunden.

Der Eingangsteil 1 umfasst mehrere Schichten 11, die piezoelektrische Keramik enthalten. Zwischen je zwei piezoelektrischen Schichten ist eine Innenelektrode 12, 13, 12', 13' angeordnet. Die im Eingangsteil angeordneten Innenelektroden unterschiedlicher Polarität sind mit 12 und 13 und die im Ausgangsteil angeordneten Innenelektroden unterschiedlicher Polarität mit 22 und 23 bezeichnet. Die ersten Innenelektroden 12 sind mittels einer auf der Oberfläche des Transformators angeordneten Außenelektrode 14 leitend miteinander verbunden. Die zweiten Innenelektroden 13 sind mittels einer Außenelektrode 15 miteinander verbunden. Die ersten und die zweiten Innenelektroden sind abwechselnd angeordnet.

Der Ausgangsteil 2 des Transformators ist in einer ähnlichen Art und Weise aufgebaut. Zwischen zwei piezoelektrischen Schichten 21 sind die ersten Innenelektroden 22 und die zweiten Innenelektroden 23 angeordnet. Die Innenelektroden derselben Polarität 22 oder 23 sind durch auf der Oberfläche des Transformators angeordnete Außenelektroden 24 bzw. 25 leitend miteinander verbunden. Die Außenelektroden 14, 15 und 24, 25 sind mittels der Verbindungsdrähte 16, 17 und 26, 27 mit einer externen elektrischen Schaltung verbindbar.

Die piezoelektrischen Schichten im Eingangsteil 1 und Ausgangsteil 2 sind jeweils in einer zu den Innenelektroden 12, 13, 22 und 23 senkrechten Richtung polarisiert. Das Verhältnis zwischen der Dicke der Keramikschichten 11, 21 im Eingangsteil 1 und im Ausgangsteil 2 bestimmt das Spannungs- und Stromtransformationsverhältnis des Transformators.

Obgleich in dem in Fig. 1 gezeigten Transformator sowohl der Eingangsteil 1 als auch der Ausgangsteil 2 eine mehrschichtige Struktur aufweist, ist dies nicht zwangsläufig erforderlich. Die vorliegende Erfindung ist auch auf piezoelektrische Transformatoren anwendbar, bei denen nur ein Teil - entweder der Eingangsteil oder der Ausgangsteil - eine mehrschichtige Struktur aufweist.

Mehrschichtige piezoelektrische Transformatoren, wie der in Fig. 1 gezeigte, weisen in einer bevorzugten Variante eine nachstehend erläuterte Einschränkung bezüglich der lateralen Ausdehnung des Transformators (in Fig. 1 ist dies die Gesamtbreite W des Grundkörpers) und bezüglich des Abstands $T_{in}$ bzw. $T_{out}$ zwischen den Innenelektroden auf. $T_{in}$ bezieht sich auf den Abstand zwischen den aufeinander folgenden Innenelektroden im Eingangsteil und $T_{out}$ auf einen solchen Abstand im Ausgangsteil.

Um die piezoelektrischen Schichten 11 und 21 im Eingangsteil und Ausgangteil des Transformators zu polarisieren, muss zwischen den Innenelektroden unterschiedlicher Polarität - 12 und 13 im Eingangsteil bzw. 22 und 23 im Ausgangsteil - eine elektrische Spannung angelegt werden.

Die Eigenschaften von Keramik und die elektrische Performance des Transformators hängen stark von der Stärke des elektrischen Feldes ab, das innerhalb jeder Keramikschicht bei angelegter Spannung während der Polarisierung erzeugt wird. Eine derartige Eigenschaft ist der elektromechanische Koppelfaktor der Keramik. Je größer dieser Faktor ist, umso besser ist die Performance des Transformators. Hohe Werte für den Koppelfaktor erhält man typischerweise durch Polarisieren der Keramik mit einem elektrischen Feld in der Größenordnung mehrerer kV/mm.

Die Größe der angelegten Spannung während der Polarisierung ist weitgehend durch die Breite $W_{iso, in}$, $W_{iso, out}$ eines Isolationsbereichs zwischen dem Rand der Innenelektrode und der auf der Oberfläche des Transformators angeordneten, diesem Rand zugewandten, aber von dieser Innenelektrode elektrisch isolierten Außenelektrode begrenzt. Für den Eingangsteil ist dies der Abstand $W_{iso, in}$ zwischen den ersten Innenelektroden 12 und der zweiten Außenelektrode 15 bzw. der Abstand $W_{iso, in}$ zwischen den zweiten Innenelektroden 13 und der ersten Außenelektrode 14. Für den Ausgangsteil ist dies der Abstand $W_{iso, out}$ zwischen den ersten Innenelektroden 22 und der zweiten Außenelektrode 25 bzw. der Abstand $W_{iso, in}$ zwischen den zweiten Innenelektroden 23 und der ersten Außenelektrode 24.

Während der Polarisierung am Eingangs- oder Ausgangsteil des Transformators wird eine Spannung angelegt. Das dabei zwischen der Außenelektrode und dem Rand der Innenelektrode entstehende elektrische Feld kann stärker sein als das elektrische Feld zwischen zwei einander gegenüber liegenden Innenelektroden 12, 13 bzw. 22, 23 der entgegengesetzten Polarität, da das elektrische Feld zwischen einer leitenden Fläche und einem scharfen Rand einer quer zu ihr angeordneten Fläche gegenüber einem elektrischen Feld zwischen zwei im wesentlich parallel zueinander liegenden Flächen größer ist. Als Folge davon kann es zu einem elektrischen Durchschlag durch den Isolationsbereich kommen.

Um in der Lage zu sein, ein elektrisches Feld zu erzeugen, das stark genug ist, um gute Eigenschaften piezoelektrischer Keramik zu gewährleisten, und den elektrischen Durchschlag zu vermeiden, muss die Breite $W_{iso, in}$ des Isolationsbereichs größer als der Abstand $T_{in}$ zwischen den Innenelektroden 12 und 13 bzw. die Breite $W_{iso, out}$ größer als der Abstand $T_{out}$ zwischen den Innenelektroden 22 und 23 sein, d. h. $W_{iso, in} \geq T_{in}$ und/oder $W_{iso, out} \geq T_{out}$. In einer vorteilhaften Variante gilt: $W_{iso, in} \geq n \times T_{in}$ für den Eingangsteil 1 und $W_{iso, out} \geq n \times T_{out}$ für den Ausgangsteil 2 des Transformators, wobei der Faktor n typischerweise gleich zwei oder größer als zwei ist.

Als aktiver Bereich wird ein Grundkörperbereich bezeichnet, in dem sich die Innenelektroden der unterschiedlichen Polarität überlappen. Als Isolationsbereich wird ein Grundkörperbereich bezeichnet, in dem nur die Innenelektroden einer Polarität angeordnet sind.

Die Breite $W_{in}$ des Eingangsteils des Grundkörpers hängt wie folgt von der Breite $W_{iso, in}$ des Isolationsbereichs und der Breite $W_{act, in}$ des aktiven Bereichs ab:

$$W_{in} = W_{act,in} + 2 \times W_{iso,in}.$$

Die Breite $W_{out}$ des Ausgangsteils des Grundkörpers hängt wie folgt von der Breite $W_{iso, out}$ des Isolationsbereichs und der Breite $W_{act,out}$ des aktiven Bereichs ab:

$$W_{out} = W_{act,out} + 2 \times W_{iso,out}.$$

Vorzugsweise gilt $W_{in} = W_{out} = W$, d. h. die Breite des Grundkörpers ist konstant.

Die Vergrößerung der Breite des Isolationsbereichs zur Vermeidung des Durchschlags führt daher zur Verringerung des aktiven Bereichs relativ zur Gesamtbreite des Transformators, falls die Gesamtbreite W des Grundkörpers konstant bleibt.

Dabei ist es nachteilig, dass die Verringerung des aktiven Bereichs typischerweise die elektrischen Eigenschaften des Transformators, insbesondere dessen Effizienz mindert.

Die Verringerung des aktiven Bereichs relativ zur Gesamtbreite des Piezotransformators aufgrund einer vergrößerten Breite des Isolationsbereichs kann in den nachstehend erläuterten Ausführungsbeispielen vermieden werden.

Die Idee der Lösung besteht darin, den Eingangsteil 1 oder den Ausgangsteil 2 des Transformators in mehrere Abschnitte zu unterteilen und diese elektrisch so miteinander zu verbinden, dass die an jedem Abschnitt anliegende Spannung gegenüber der am Eingangsteil angelegten Gesamtspannung um einen Faktor reduziert wird, der im Wesentlichen gleich der Anzahl der Abschnitte ist.

Die elektrische Feldstärke im Isolationsbereich des jeweiligen Abschnitts ist proportional zu der an diesem Abschnitt anliegenden Spannung. Die Verringerung der an den jeweiligen Abschnitt des Grundkörperteils angelegten Spannung verringert die Wahrscheinlichkeit eines elektrischen Durchschlags durch den Isolationsbereich, weil dabei die Feldstärke im Isolationsbereich verringert wird.

Die Verringerung der an jedem Abschnitt anliegenden Spannung führt zur Verringerung der elektrischen Feldstärke in den Keramikschichten 11 bzw. 21. Um dieses Feld unverändert zu lassen, wird in einer Variante die Dicke der Schichten proportional zur Anzahl der Abschnitte verringert. In diesem Fall kann eine vorgegebene Polarisierung von Keramik ohne elektrischen Durchschlag durch den Isolationsbereich erzielt werden.

Die Anzahl der Abschnitte im Eingangsteil 1 und/oder dem Ausgangsteil 2 des Transformators so groß gewählt werden, dass dabei die Verringerung der Breite des Isolationsbereichs $W_{iso, in}$ im Eingangsteil 1 bzw. $W_{iso, out}$ im Ausgangsteil 2 des Transformators relativ zur Gesamtbreite des Transformators möglich ist, ohne die Gefahr des elektrischen Durchschlags durch den Isolationsbereich zu erhöhen. In diesem Fall wird die Breite des aktiven Bereichs relativ zur Gesamtbreite des Transformators größer, was vorteilhaft für die gute Leistung des Transformators ist.

Trotz der Änderung in der Dicke der Keramikschichten im Eingangsteil 1 und/oder dem Ausgangsteil 2, nachdem diese in mehrere Abschnitte aufgeteilt worden sind, bleibt die Spannungstransformation des Transformators in einer bevorzugten Variante erhalten. Dies ist der Fall, falls die Abschnitte derart miteinander verbunden sind, dass dabei die Änderung der Dicke der Keramikschichten kompensiert ist. Die Dicke der Keramikschichten kann z. B. umgekehrt proportional zur Anzahl der Abschnitte verringert werden. Beispielsweise kann diese Dicke bei zwei in Serie elektrisch miteinander verbundenen Abschnitten im Wesentlichen halbiert werden.

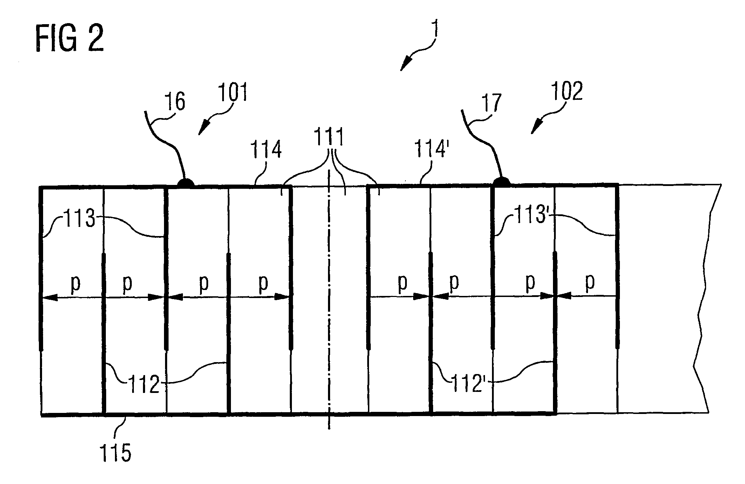

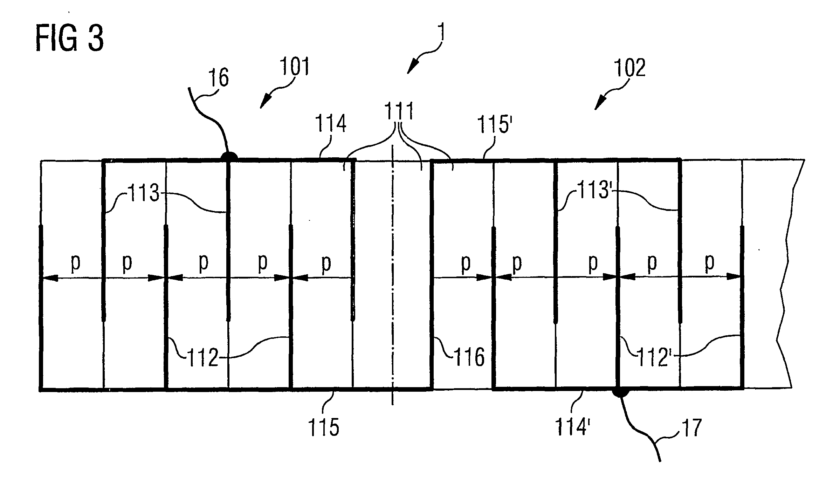

Figur 2 zeigt einen Grundkörperteil des mehrschichtigen piezoelektrischen Transformators, außerhalb des Schutzbereichs der Ansprüche, hier den Eingangsteil 1. Die Beschreibung des Eingangsteil in Fig. 2 und 3 ist ohne Einschränkung der Allgemeinheit auch auf den Ausgangsteil des Transformators anwendbar.

Auf der Oberfläche des Grundkörpers des piezoelektrischen Transformators ist eine gemeinsame Außenelektrode 115 angeordnet. Der Eingangsteil 1 ist in zwei Abschnitte 101 und 102 unterteilt. Diese Abschnitte umfassen Keramikschichten 111, zwischen denen Innenelektroden 112, 113, 112', 113' angeordnet sind. Die ersten Innenelektroden 112, 112' der Abschnitte 101 und 102 sind mittels der Außenelektrode 115 elektrisch so verbunden, dass die Außenelektrode 115 den beiden Abschnitten 101 und 102 gemeinsam ist. Die zweiten Innenelektroden 113 sind mittels der ersten Außenelektrode 114 miteinander verbunden. Die dritten Innenelektroden 113' sind mittels der zweiten Außenelektrode 114' miteinander verbunden. Die piezokeramischen Schichten sind in jedem Abschnitt in der Richtung senkrecht zu den Innenelektroden 112, 113, 112' und 113' polarisiert. Bezüglich der Innenelektroden 112, 112' ist die elektrische Polarisierung in den Keramikschichten im Abschnitt 102 gegenüber der elektrischen Polarisierung in den Keramikschichten in Abschnitt 101 entgegengesetzt gerichtet. Die Anschlussdrähte 16 und 17 sind zum Zwecke der elektrischen Anbindung des Eingangsteils 1 des piezoelektrischen Transformators an eine externe elektrische Schaltung an die Außenelektroden 114 und 114' angeschlossen.

Figur 3 zeigt ausschnittsweise einen Teil des anspruchsgemäßen mehrschichtigen piezoelektrischen Transformators, hier den Eingangsteil 1. Der Eingangsteil 1 ist in zwei Abschnitte 101 und 102 unterteilt. Im Unterschied zu dem Transformator gemäß der Figur 2 weist die Sammelelektrode, an die die ersten Innenelektroden der beiden Abschnitte 101 und 102 angeschlossen sind, drei Teile auf: eine dritte Außenelektrode 115 und eine vierte Außenelektrode 115', die auf zwei unterschiedlichen - hier gegenüber liegenden - Seitenflächen des Transformators angeordnet sind, und eine Innenelektrode 116, die diese leitend verbindet. Diese Innenelektrode 116 ist in der Figur 3 als eine in den Grundkörper des piezoelektrischen Transformators einbezogene Innenelektrode gezeigt. Als eine alternative nicht anspruchsgemäße Lösung kann die Verbindung zwischen den Elektroden 115 und 115' mittels eines außerhalb des Grundkörpers verlaufenden Drahtes oder mittels einer zumindest teilweise entlang der Oberfläche des Grundkörpers verlaufenden Verbindung erfolgen.

Bezugszeichenliste

| | |
|---|---|
| I | Grundkörper |
| 1 | Eingangsteil |
| 2 | Ausgangsteil |
| 12, 13 | Innenelektroden des Eingangsteils |

| 22, 23 | Innenelektroden des Ausgangsteils |
| 14, 15 | Außenelektroden des Eingangsteils |
| 24, 25 | Außenelektroden des Ausgangsteils |
| 16, 17, 26, 27 | Anschlussdrähte |
| 101 | erster Abschnitt des Eingangsteils 1 |
| 102 | zweiter Abschnitt des Eingangsteils 1 |
| 11, 111, 21 | piezoelektrische Schichten |
| 112, 112' | erste Innenelektroden |
| 113 | zweite Innenelektroden |
| 113' | dritte Innenelektroden |
| 114 | erste Außenelektrode des Eingangsteils 1 |
| 114' | zweite Außenelektrode des Eingangsteils 1 |
| 115 | dritte Außenelektrode |
| 115' | vierte Außenelektrode |
| 116 | Innenelektrode, die die dritte und die vierte Außenelektrode 115, 115' verbindet |
| p | Vektor der Polarisation |
| $T_{in}$ | Dicke der piezoelektrischen Schicht 111 im Eingangsteil |
| $T_{out}$ | Dicke der piezoelektrischen Schicht 111 im Ausgangsteil |
| $W_{iso, in}$ | Ausdehnung des Randbereichs im Eingangsteil |
| $W_{act, in}$ | Ausdehnung des aktiven Bereichs im Eingangsteil |
| $W_{iso, out}$ | Ausdehnung des Randbereichs im Ausgangsteil |
| $W_{act, out}$ | Ausdehnung des aktiven Bereichs im Ausgangsteil |

**Patentansprüche**

1. Piezoelektrischer Transformator

    - mit einem Grundkörper,
    - mit einem Eingangsteil (1) und einem Ausgangsteil (2), die jeweils einen zusammenhängenden Teil des Grundkörpers bilden,
    - wobei in wenigstens einem dieser Teile (1, 2) mindestens drei Gruppen von Innenelektroden (112, 113, 112', 113') enthalten sind,
    - wobei die Innenelektroden (112, 112') jeweils einer Gruppe untereinander elektrisch leitend verbunden sind und von den Innenelektroden (113, 113') einer anderen Gruppe elektrisch isoliert sind,
    - wobei wenigstens einer der beiden Grundkörperteile (1, 2) in mindestens zwei Abschnitte (101, 102) unterteilt ist,
    - wobei in einem ersten Abschnitt (101) und einem dazu benachbarten zweiten Abschnitt (102) angeordnete erste Innenelektroden (112, 112') leitend miteinander verbunden sind und eine erste Gruppe bilden,

    - **dadurch gekennzeichnet, dass** die im ersten Abschnitt (101) angeordneten ersten Innenelektroden (112) an eine dritte Außenelektrode (115) und die im zweiten Abschnitt (102) angeordneten ersten Innenelektroden (112') an eine vierte Außenelektrode (115') angeschlossen sind, und die dritte und die vierte Außenelektrode (115, 115') an unterschiedlichen Seitenflächen des Grundkörpers angeordnet und mittels einer In-nenelektrode (116) leitend miteinander verbun-den sind.

2. Piezoelektrischer Transformator nach Anspruch 1, wobei wenigstens einer der beiden Grundkörperteile (1, 2) unterteilt ist in mindestens zwei Abschnitte (101, 102),
   wobei in einem ersten Abschnitt (101) und einem dazu benachbarten zweiten Abschnitt (102) angeordnete erste Innenelektroden (112, 112') leitend miteinander verbunden sind und eine erste Gruppe bilden,
   wobei eine zweite Gruppe von zweiten Innenelektroden (113) vorgesehen ist, die auf den ersten Abschnitt (101) beschränkt ist, und
   wobei eine dritte Gruppe von dritten Innenelektroden (113') vorgesehen ist, die auf den zweiten Abschnitt (102) beschränkt ist.

3. Piezoelektrischer Transformator nach Anspruch 2, wobei die im ersten Abschnitt (101) angeordneten ersten (112) und die zweiten (113) Innenelektroden zur Bildung einer ersten Kapazität abwechselnd übereinander angeordnet sind,
   wobei die im zweiten Abschnitt (102) angeordneten ersten (112') und die dritten (113') Innenelektroden zur Bildung einer zweiten Kapazität abwechselnd übereinander angeordnet sind, und
   wobei die erste und die zweite Kapazität in Serie geschaltet sind.

4. Piezoelektrischer Transformator nach Anspruch 2 oder 3,
   wobei die zweiten Innenelektroden (113) an eine erste Außenelektrode (114) dieses Grundkörperteils angeschlossen sind.

5. Piezoelektrischer Transformator nach einem der Ansprüche 1-4,
   wobei eine endständige zweite Innenelektrode (113) und eine endständige dritte Innenelektrode (113') zueinander gewandt sind.

6. Piezoelektrischer Transformator nach Anspruch 5, wobei die Innenelektrode (116), die die dritte und die vierte Außenelektrode (115, 115') verbindet, zwischen einer endständigen zweiten Innenelektrode (113) und einer endständigen dritten Innenelektrode (113') angeordnet ist.

7.  Piezoelektrischer Transformator nach einem der Ansprüche 2 bis 6,
    wobei der Grundkörper piezoelektrische Schichten (111) aufweist, zwischen denen die Innenelektroden (112, 113, 112', 113') angeordnet sind,
    wobei in den benachbarten Abschnitten die Polarisation der piezoelektrischen Schichten (111) bezogen auf die ersten Innenelektroden (112, 112') entgegengesetzt gerichtet ist.

8.  Piezoelektrischer Transformator nach einem der Ansprüche 2 bis 7,
    wobei der Grundkörper piezoelektrische Schichten (111) aufweist, zwischen denen die Innenelektroden (112, 113, 112', 113') angeordnet sind,
    wobei für mindestens einen der Grundkörperteile gilt: die Dicke der piezoelektrischen Schichten (111) ist kleiner als der Abstand (Wiso, in, Wiso, out) zwischen den Rändern der Innenelektroden (112; 113) einer Gruppe und einer an der Grundkörperoberfläche angeordneten, diesen Innenelektroden zugewandten, aber elektrisch von diesen isolierten Außenelektrode (114; 115).

**Claims**

1.  Piezoelectric transformer

    - having a base body,
    - having an input part (1) and output part (2), which respectively form a contiguous part of the base body,
    - at least three groups of inner electrodes (112, 113, 112', 113') being contained in at least one of these parts (1, 2),
    - the inner electrodes (112, 112') of each group being connected to one another in an electrically conducting manner and electrically insulated from the inner electrodes (113, 113') of another group,
    - at least one of the two base body parts (1, 2) being subdivided into at least two portions (101, 102),
    - first inner electrodes (112, 112') that are arranged in a first portion (101) and a second portion (102) adjacent thereto being connected to one another in a conducting manner and forming a first group,

    **characterized in that** the first inner electrodes (112) arranged in the first portion (101) are connected to a third outer electrode (115) and the first inner electrodes (112') arranged in the second portion (102) are connected to a fourth outer electrode (115') and the third and fourth outer electrodes (115, 115') are arranged on different side faces of the base body and are connected to one another in a conducting manner by means of an inner electrode (116).

2.  Piezoelectric transformer according to Claim 1,
    at least one of the two base body parts (1, 2) being subdivided into at least two portions (101, 102),
    first inner electrodes (112, 112') that are arranged in a first portion (101) and a second portion (102) adjacent thereto being connected to one another in a conducting manner and forming a first group,
    a second group of second inner electrodes (113), which is restricted to the first portion (101), being provided and
    a third group of third inner electrodes (113'), which is restricted to the second portion (102), being provided.

3.  Piezoelectric transformer according to Claim 2,
    the first (112) and second (113) inner electrodes that are arranged in the first portion (101) being arranged alternately one above the other to form a first capacitance,
    the first (112') and third (113') inner electrodes that are arranged in the second portion (102) being arranged alternately one above the other to form a second capacitance, and
    the first and second capacitances being connected in series.

4.  Piezoelectric transformer according to Claim 2 or 3,
    the second inner electrodes (113) being connected to a first outer electrode (114) of this base body part.

5.  Piezoelectric transformer according to one of Claims 1 to 4,
    a second inner electrode (113) at the end and a third inner electrode (113') at the end facing each other.

6.  Piezoelectric transformer according to Claim 5,
    the inner electrode (116) which connects the third and fourth outer electrodes (115, 115') being arranged between a second inner electrode (113) at the end and a third inner electrode (113') at the end.

7.  Piezoelectric transformer according to one of Claims 2 to 6,
    the base body having piezoelectric layers (111) between which the inner electrodes (112, 113, 112', 113') are arranged,
    the polarization of the piezoelectric layers (111) being directed oppositely from that of the first inner electrodes (112, 112') in the adjacent portions.

8.  Piezoelectric transformer according to one of Claims 2 to 7,
    the base body comprising piezoelectric layers (111) between which the inner electrodes (112, 113, 112', 113') are arranged,
    the following applying to at least one of the base body parts:

the thickness of the piezoelectric layers (111) is less than the distance (Wiso, in, Wiso, out) between the edges of the inner electrodes (112; 113) of a group and an outer electrode (114; 115) that is arranged on the surface of the base body and facing these inner electrodes but electrically insulated from them.

## Revendications

1. Transformateur piézo-électrique

- comprenant un corps de base,
- ayant une partie (1) d'entrée et une partie (2) de sortie qui forment respectivement une partie d'un seul tenant du corps de base,
- dans lequel dans au moins l'une de ces parties (1, 2) sont contenus au moins trois groupes d'électrodes (112, 113, 112', 113') intérieures,
- dans lequel les électrodes (112, 113, 112', 113') intérieures d'un groupe sont reliées entre elles d'une manière conductrice de l'électricité et sont isolées électriquement des électrodes (113, 113') intérieures d'un autre groupe,
- dans lequel au moins l'une des deux parties (1, 2) du corps de base est subdivisée en au moins deux segments (101, 102),
- dans lequel des premières électrodes (112, 112') intérieures disposées dans un premier segment (101) et dans un deuxième segment (102) voisin de celui-ci sont reliées entre elles d'une manière conductrice et forment un premier groupe,
**caractérisé en ce que**
- les premières électrodes (112) intérieures disposées dans le premier segment (101) sont raccordées à une troisième électrode (115) extérieure et les premières électrodes (112') intérieures disposées dans le deuxième segment (102) sont raccordées à une quatrième électrode (115') extérieure, et la troisième et la quatrième électrodes (115, 115') extérieures sont disposées sur des surfaces latérales du corps de base et sont reliées entre elles d'une manière conductrice au moyen d'une électrode (116) intérieure.

2. Transformateur piézo-électrique suivant la revendication 1,
dans lequel au moins l'une des deux parties (1, 2) du corps de base est subdivisée en au moins deux segments (101, 102),
dans lequel des premières électrodes (112, 112') intérieures disposées dans un premier segment (101) et dans un deuxième segment (102) voisin de celui-ci des électrodes (112, 112') intérieures sont reliées entre elles d'une manière conductrice et forment un premier groupe,
dans lequel il est prévu un deuxième groupe de deuxièmes électrodes (113) intérieures, qui est limité au premier segment (101), et
dans lequel il est prévu un troisième groupe de troisièmes électrodes (113') intérieures, qui est limité au deuxième segment (102).

3. Transformateur piézo-électrique suivant la revendication 2,
dans lequel les premières électrodes (112) intérieures et deuxièmes électrodes (113) intérieures disposées dans le premier segment (101) sont disposées en étant superposées en alternance pour la formation d'une première capacité,
dans lequel les premières électrodes (112') intérieures et les troisièmes électrodes (113') intérieures disposées dans le deuxième segment (102) sont disposées en étant superposées en alternance pour la formation d'une deuxième capacité, et
dans lequel la première et la deuxième capacité sont montées en série.

4. Transformateur piézo-électrique suivant la revendication 2 ou 3,
dans lequel les deuxièmes électrodes (113) intérieures sont raccordées à une première électrode (114) extérieure de cette partie du corps de base.

5. Transformateur piézo-électrique suivant l'une des revendications 1 à 4,
dans lequel une deuxième électrode (113) intérieure à l'extrémité et une troisième électrode (113') intérieure à l'extrémité sont tournées l'une vers l'autre.

6. Transformateur piézo-électrique suivant la revendication 5,
dans lequel l'électrode (116) intérieure qui relie la troisième et la quatrième électrode (115, 115') extérieure est disposée entre une deuxième électrode (113) intérieure à l'extrémité et une troisième électrode (113') intérieure à l'extrémité.

7. Transformateur piézo-électrique suivant l'une des revendications 2 à 6,
dans lequel le corps de base a des couches (111) piézo-électrique entre lesquelles sont disposées les électrodes (112, 113, 112', 113') intérieures,
dans lequel dans les segments voisins la polarisation des couches (111) piézo-électriques est dirigée de manière opposée rapportée aux premières électrodes (112, 112') intérieures.

8. Transformateur piézo-électrique suivant l'une des revendications 1 à 7,
dans lequel le corps de base a des couches (111) piézo-électriques entre lesquelles sont disposées les électrodes (112, 113, 112', 113') intérieures, dans lequel pour au moins l'une des parties du corps de base : l'épaisseur des couches (111) piézo-électriques est plus petite que la distance (Wiso, in, Wiso, out) entre les bords des électrodes (112 ; 113) intérieures d'un groupe et une électrode (114 ; 115) extérieure disposée à la surface du corps de base tournée vers ces électrodes intérieures, mais en étant isolée électriquement.

FIG 1

EP 1 776 725 B1

FIG 2

EP 1 776 725 B1

FIG 3

EP 1 776 725 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2830274 A
- JP 7059338 A

- US 200274903 A1